# FASCICULE DE BREVET EUROPEEN

(11) **EP 3 878 062 B1**
(45) Date de publication et mention de la délivrance du brevet: **27.07.2022**
(21) Numéro de dépôt: 19790017.8
(22) Date de dépôt: 24.10.2019
(51) Int. Cl.: H01S 3/07, H01S 3/102, H01S 3/23, H01S 3/04, H01S 3/042, H01S 3/06

(54) **TETE AMPLIFICATRICE LASER DE HAUTE PUISSANCE**
HOCHLEISTUNGSLASERVERSTÄRKERKOPF
HIGH-POWER LASER AMPLIFIER HEAD

(30) Priorité: 06.11.2018 FR 1860215
(43) Date de publication de la demande: 15.09.2021
(73) Titulaire: Centre national de la recherche scientifique, 75016 Paris (FR)
(72) Inventeur: FERAL, Christophe, 33127 MARTIGNAS SUR JALLE (FR); LHERMITE, Jérôme, 64600 ANGLET (FR); BRANDAM, Jérémy, 33400 TALENCE (FR); MARION, Denis, 33600 PESSAC (FR)
(74) Mandataire: Marks & Clerk France
(86) Numéro de dépôt international: PCT/EP2019/079111
(87) Numéro de publication internationale: WO 2020/094416

(56) Documents cités:
- EP-A2- 2 795 745
- US-A1- 2006 007 800
- KE WANG ET AL: "7kW direct-liquid-cooled side-pumped Nd:YAG multi-disk laser resonator", OPTICS EXPRESS, vol. 24, no. 13, 23 juin 2016 (2016-06-23) , page 15012, XP055608704, DOI: 10.1364/OE.24.015012 cité dans la demande
- SANTANU BASU: "A design for a 100kW rotary disk laser oscillator with good beam quality", PROCEEDINGS SPIE 7513, 2009 INTERNATIONAL CONFERENCE ON OPTICAL INSTRUMENTS AND TECHNOLOGY, vol. 7578, 11 février 2010 (2010-02-11), page 75780D, XP055609220, 1000 20th St. Bellingham WA 98225-6705 USA ISSN: 0277-786X, DOI: 10.1117/12.846420 ISBN: 978-1-5106-2781-9

## Description

L'invention porte sur une tête amplificatrice laser à état solide, destinée à être utilisée à haute puissance (puissance moyenne de l'ordre de 1 kW ou plus, impulsions de l'ordre de 1 J ou plus). La tête laser de l'invention est particulièrement adaptée à la réalisation d'un amplificateur laser, mais peut également être placée à l'intérieur d'une cavité optique pour réaliser un oscillateur ou un amplificateur régénératif.

Lors de la conception d'un laser à état solide, en particulier destiné à travailler à des puissances élevées, le refroidissement du milieu actif revêt une importance particulière. En effet, une température excessive affecte défavorablement la capacité d'amplification ainsi que la qualité optique du faisceau laser (effet de lentille thermique, déformations du milieu actif) et sa polarisation (biréfringence induite par le stress), et peut même provoquer la dégradation ou la rupture du milieu actif.

Il est connu de façonner le milieu actif en forme de plaque ou disque, avec typiquement une épaisseur inférieure - voire très inférieure - à un dixième de ses dimensions latérales. Le refroidissement peut alors se faire de plusieurs façons :
- Par la monture, reliée à un circuit de refroidissement interne.
- Par la surface arrière, réfléchissante, ce qui impose des épaisseurs très faibles de milieu actif (300 micromètres typiquement), et donc un grand nombre (typiquement 12 ou plus) de passages. C'est la technologie dite de disque mince (« thin disk » en anglais) ou de « miroir actif » pour des épaisseurs plus importantes (« active mirror » en anglais). Voir par exemple [1a], [1b], [1c].
- Par un fluide incident sur les surfaces principales du disque ; ce fluide est le plus souvent un gaz, mais il peut parfois s'agir d'un liquide. Par exemple, [2] décrit un oscillateur laser dont le milieu actif est formé de deux plaques minces de Nd:YAG inclinées à l'angle de Brewster par rapport au trajet optique du faisceau laser et formant un angle entre elles, immergées dans un écoulement de liquide de refroidissement. Les documents [3] et [4] décrivent des oscillateurs laser dont le milieu actif est formé par un empilement de disques d'une épaisseur de l'ordre du millimètre, un liquide de refroidissement (D₂O) circulant dans les espaces entre les disques. En outre, KE WANG ET AL: "7kW direct-liquid-cooled side-pumped Nd:YAG multi-disk laser resonator", OPTICS EXPRESS, vol. 24, no. 13, 23 juin 2016, page 15012 décrit une tête amplificatrice laser comme définie dans le préambule de la revendication 1.

Il est également connu de mettre en rotation un milieu actif de grandes dimensions par rapport au diamètre du faisceau laser, le faisceau laser étant excentré par rapport à l'axe de rotation. La chaleur est alors stockée dans un plus grand volume et échangée sur une plus grande surface, ce qui atténue fortement les effets techniques. Voir à ce propos [5], [6] et [7].

L'invention vise à procurer une tête amplificatrice laser présentant un refroidissement plus efficace que selon l'art antérieur, permettant donc d'atteindre un niveau de puissance plus élevé, sans dégradation (voire avec une amélioration) de la qualité optique du faisceau laser.

Conformément à l'invention, ce but est atteint par une tête laser dont le milieu actif est constitué par un empilement de plaques minces en rotation autour d'un axe commun (ou, plus généralement, présentant un mouvement cyclique) et immergés dans un écoulement liquide.

L'utilisation combinée d'une pluralité de plaques minces en mouvement et d'un refroidissement par liquide pose une difficulté particulière : en effet, en l'absence de précautions particulières, l'écoulement liquide a tendance à devenir turbulent, ce qui dégrade fortement la qualité du faisceau laser (par exemple, l'article [8] illustre les effets de la turbulence dans le cas d'un oscillateur laser à disque mince sans parties en mouvement). L'invention résout ce problème par l'utilisation de plaques de guidage du liquide de refroidissement agencées dans le prolongement des plaques de milieu actif laser, qui assurent un écoulement laminaire au passage du faisceau laser.

Un autre aspect de l'invention consiste dans une évacuation efficace du rayonnement d'amplification stimulée, rendue possible par l'utilisation de plaques de guidage du liquide de refroidissement transparentes, de préférence associées à des miroirs qui dévient le rayonnement vers une région absorbante et diffusante.

Un objet de l'invention est donc une tête amplificatrice laser comprenant une pluralité de plaques d'un milieu actif laser à état solide disposées dans un carter, agencées parallèles les unes aux autres avec leurs surfaces principales en vis-à-vis, par exemple alignées selon une direction de propagation d'un faisceau laser, le carter étant pourvu d'un port d'entrée et d'un port de sortie pour un liquide de refroidissement, ainsi que d'au moins une fenêtre permettant à un faisceau laser de traverser les plaques de milieu actif laser, caractérisé en ce qu'elle comprend également :
- un dispositif de liaison mécanique permettant un mouvement cyclique au moins des plaques de milieu actif laser par rapport au faisceau laser dans un plan perpendiculaire à la direction de leur épaisseur ; et
- des plaques de guidage du liquide de refroidissement agencées dans le prolongement des plaques de milieu actif laser, entre ces dernières et le port d'entrée dudit liquide.

Selon des modes de réalisation particuliers de l'invention :
- Le dispositif de liaison mécanique peut être configuré pour mettre les plaques de milieu actif laser en rotation autour d'un axe commun, perpendiculaire à la direction de leur épaisseur, par rapport au carter. L'axe commun peut notamment être parallèle à la direction de propagation du faisceau laser. En outre, la ou les fenêtres peuvent être agencées de telle sorte que le faisceau laser traverse une région desdites plaques de milieu actif laser comprise entre le port d'entrée du liquide de refroidissement et l'axe commun de rotation.
- Les plaques de guidage du liquide de refroidissement peuvent être transparentes dans une bande spectrale d'un rayonnement d'émission spontanée amplifiée des plaques de milieu actif laser, de manière à permettre l'évacuation dudit rayonnement. Dans ce cas, la tête amplificatrice peut comprendre également des miroirs pour dévier une portion dudit rayonnement d'émission spontanée amplifiée évacuée à travers les plaques de guidage du liquide de refroidissement et initialement dirigée vers le port d'entrée du liquide de refroidissement. Par ailleurs, la tête amplificatrice peut comprendre également, à l'intérieur dudit carter, au moins une structure optiquement absorbante et diffusante dans ladite bande spectrale du rayonnement d'émission spontanée amplifiée, ladite structure optiquement absorbante et diffusante entourant au moins en partie les plaques de milieu actif laser dans un plan perpendiculaire à la direction de leur épaisseur et étant agencée de manière à être en contact avec ledit liquide de refroidissement. Ladite structure optiquement absorbante et diffusante comprend avantageusement un réseau de plots. En outre, la tête amplificatrice peut comprendre également au moins une paroi transparente dans ladite bande spectrale du rayonnement d'émission spontanée amplifiée et séparant d'une part une région du volume interne au carter contenant les plaques de milieu actif laser, les plaques de guidage du liquide de refroidissement et le port d'entrée, et d'autre part ladite ou chaque dite structure optiquement absorbante et diffusante et le port de sortie.

- Les plaques de guidage du liquide de refroidissement peuvent présenter une largeur inférieure à celle des plaques du milieu actif laser.
- Les plaques de milieu actif laser peuvent présenter une épaisseur comprise entre 300 µm et 1 cm et un espacement mutuel compris entre 200 µm et 4 mm.
- Les plaques de milieu actif laser peuvent être en forme de disque.
- La tête amplificatrice peut comprendre également une pompe reliée fluidiquement au port d'entrée et au port de sortie et adaptée pour provoquer dans le carter un écoulement du liquide de refroidissement, le dimensionnement et l'agencement de la pompe, du carter, des plaques de milieu actif laser et des plaques de guidage du liquide de refroidissement étant adaptés pour que l'écoulement soit laminaire dans une région traversée par le faisceau laser, puis effectue une transition vers un régime turbulent.
- La tête amplificatrice peut comprendre également un actionneur coopérant avec le dispositif de liaison mécanique pour provoquer ledit mouvement cyclique des plaques de milieu actif.
- La tête amplificatrice peut comprendre également un système de pompage optique longitudinal.

D'autres caractéristiques, détails et avantages de l'invention ressortiront à la lecture de la description faite en référence aux dessins annexés donnés à titre d'exemple et qui représentent, respectivement :
- La figure 1, une vue écorchée d'une tête amplificatrice laser selon un premier mode de réalisation de l'invention ;
- Les figure 2A et 2B, respectivement, une vue en coupe et en plan d'une tête amplificatrice laser selon un deuxième mode de réalisation de l'invention ;
- Les figures 3A, 3B, 3C les écoulements du liquide de refroidissement pour différentes valeurs de l'espacement et du décalage entre les plaques de guidage du liquide de refroidissement et les plaques de milieu actif laser ;
- La figure 4, un schéma du transport de rayonnement d'émission spontanée amplifiée dans la tête laser de la figure 1 ; et
- La figure 5, un schéma d'un amplificateur laser mettant en œuvre une tête amplificatrice selon l'invention.

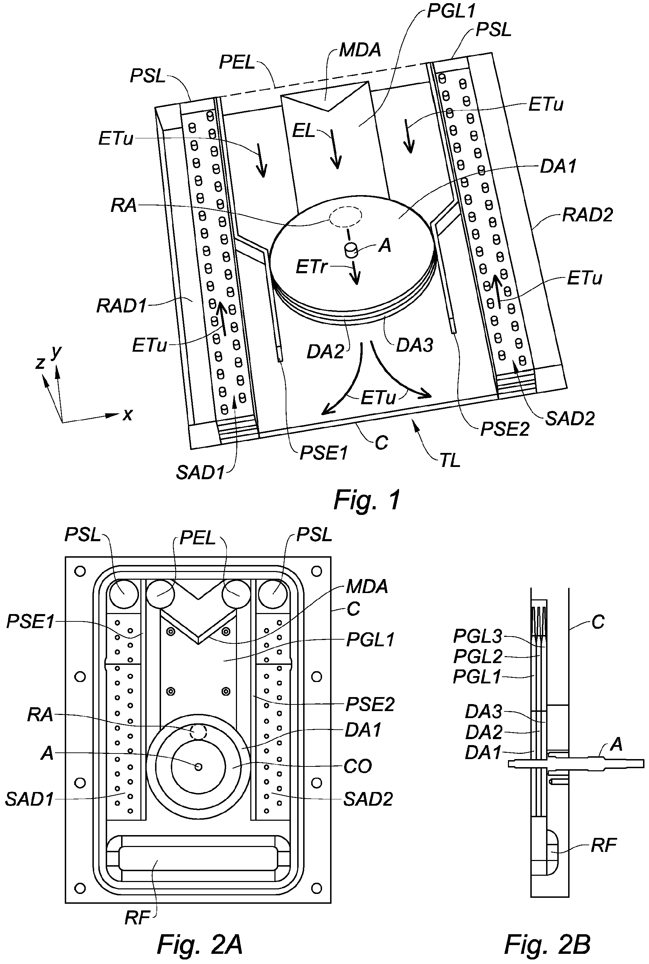

La vue écorchée de la figure 1 permet de comprendre la structure d'une tête amplificatrice laser selon un premier mode de réalisation de l'invention. Le milieu actif laser est constitué de trois plaques, plus précisément des disques, DA1, DA2, DA3 de grenat d'yttrium et aluminium (YAG) dopé avec de l'ytterbium (Yb :YAG), ayant une épaisseur de 3 mm et un diamètre de 70 mm, montés en série sur un arbre A passant par leur centre, avec un espacement entre deux disques adjacents de 500 µm. L'arbre A permet d'actionner les disques en rotation, par exemple à une vitesse comprise entre 1 et 10 tours par seconde. L'ensemble est placé à l'intérieur d'un carter C en forme de parallélépipède. On désigne par z la direction d'orientation de l'arbre A, et par x, y des axes perpendiculaires entre eux et à l'axe z définissant un plan parallèle aux surfaces principales des disques.

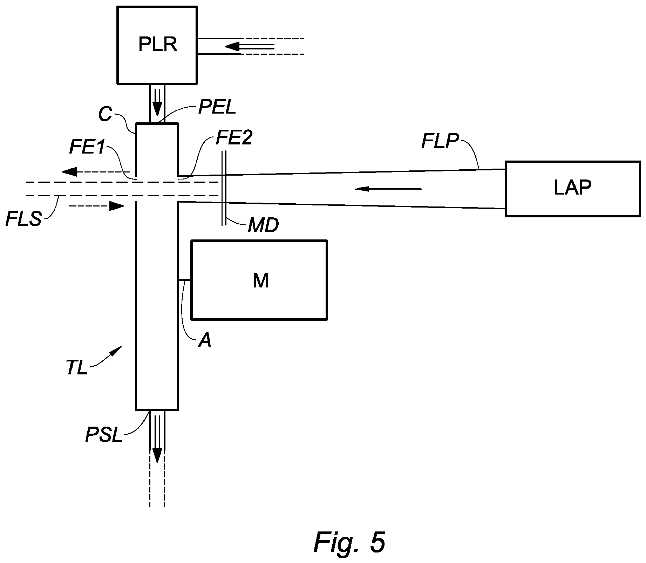

Le faisceau laser à amplifier et le faisceau laser de pompe, qui entrent et sortent du carter par des fenêtres ou hublot (voir la figure 5 pour plus de détails), passent à travers les trois disques, de manière excentrée. La référence RA désigne l'empreinte des faisceaux lasers sur le disque DA1. Du fait de la rotation, la chaleur générée par le pompage est répartie dans une couronne (référence CO sur la figure 2A). En raison de l'inertie thermique des disques, l'élévation locale de température au passage du faisceau reste limitée à quelques degrés. En outre, la chaleur est répartie sur une surface plus grande que celle du faisceau laser, la surface d'échange thermique avec le liquide de refroidissement augmente et la température du disque s'en trouve diminuée.

Avantageusement, les disques présentent des dopages différents, calculés de sorte qu'ils subissent la même charge thermique.

Le liquide de refroidissement - par exemple de l'eau lourde, D₂O, qui est moins absorbante que l'eau ordinaire (H₂O) à la longueur d'onde d'émission du Yb :YAG (1.030 nm) - rentre dans le carter par un port d'entrée PEL, s'écoule en direction des disques de matériau actif, guidé latéralement par deux parois séparatrices PSE1, PSE2 définissant un canal central. Dans le mode de réalisation de la figure 1, le canal présente initialement une largeur supérieure au diamètre des disques DA1 - DA3, puis les parois PSE1, PSE2 se rapprochent jusqu'à presque toucher les disques, ce qui a par effet d'accélérer l'écoulement. Après avoir passé la région contenant les disques, le liquide - qui rentre à 10°C puis sort chauffé de quelques degrés - remonte par deux canaux latéraux situés sur les côtés du carter et séparés du canal central par les parois PSE1, PSE2. Les canaux latéraux contiennent des réseaux de plots métalliques SAD1, SAD2, dont la fonction sera expliquée plus loin, et débouchent dans un ou plusieurs ports de sortie du liquide PSL. Des radiateurs métalliques RAD1, RAD2, formant les parois latérales du carter, permettent l'évacuation d'une partie de la chaleur transportée par le liquide.

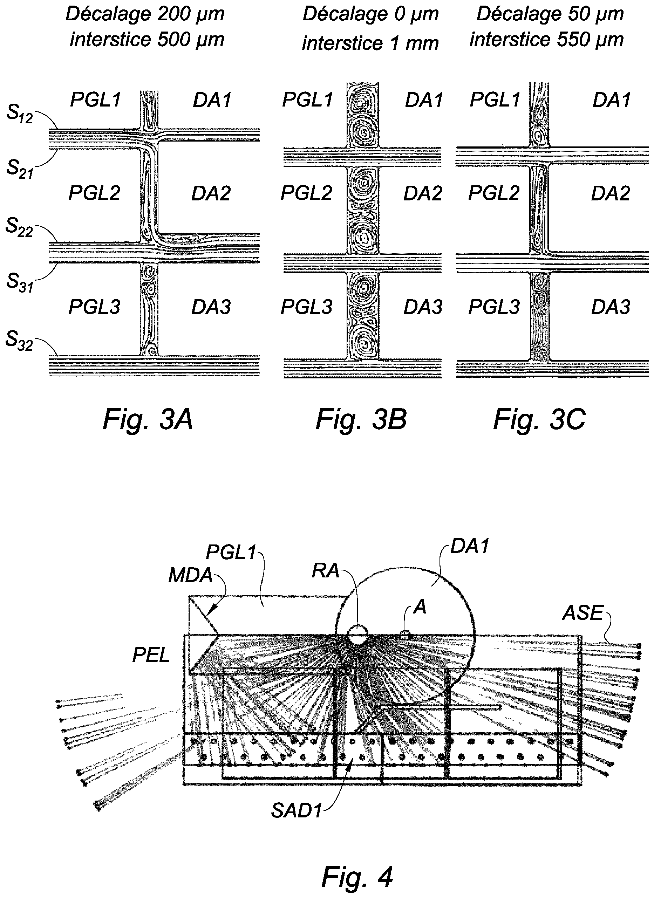

Trois plaques de guidage du liquide, PGL1, PGL2, PGL3, sont disposées dans la partie médiane du canal central. Chaque plaque de guidage du liquide présente la même épaisseur qu'un disque de matériau actif laser et se trouve dans son prolongement. L'interstice entre une plaque de guidage du liquide et le disque correspondant est de préférence inférieur ou égal à 500 µm et le décalage dans la direction de l'épaisseur des plaques (z) inférieur ou égal à 50 µm (voir les figures 3A - 3C et la discussion correspondante, ci-après).

La fonction des plaques PGL1, PGL2, PGL3 est d'assurer que l'écoulement du liquide de refroidissement soit laminaire dans la région traversée par le faisceau laser. Comme illustré sur la figure 1, l'écoulement est laminaire (EL) entre les plaques PGL1, PGL2, PGL3, et turbulent (ETu) sur les côtés du canal central. L'écoulement reste laminaire au cours des premiers centimètres qu'il parcourt entre les disques de milieu actif, et notamment en correspondance de la région RA, puis il effectue une transition vers un régime turbulent (la référence ETr désigne l'écoulement à la transition laminaire - turbulent), ce qui présente l'avantage d'augmenter le coefficient d'échange thermique. L'écoulement est turbulent en aval des disques de milieu actif, et notamment dans les canaux latéraux.

Si on considère un espace inter-disque de 500 µm et une vitesse du liquide de 2 m/s, le nombre de Reynolds local est de 2000. Or, la littérature montre que dans cette géométrie l'écoulement est laminaire jusqu'à un nombre de Reynolds de 2500 environ. La longueur de transition turbulent-laminaire est d'environ 68 mm ; on choisira donc des plaques PGL1, PGL2, PGL3 d'une longueur supérieure à cette valeur, par exemple 80 mm.

Les figures 2A et 2B illustrent un deuxième mode de réalisation dans lequel les parois PSE1, PSE2 sont rectilignes et parallèles, de telle sorte que la largeur du canal central est partout à peine supérieure au diamètre des disques. On peut également noter, dans la partie « basse » (opposée aux ports d'entrée et de sortie du liquide) une rainure RF avec des bords arrondis formant un creux qui crée une zone dans laquelle le flux peut s'étendre, donc ralentit, ce qui rend plus facile sa remontée par les côtés.

Les plaques PGL1 - PGL3 qui permettent de mettre en forme le flux d'eau laminaire en amont des disques sont fixes, alors que ces derniers sont en rotation. Il existe donc forcément un interstice entre ces deux types de pièces. En outre, en raison des inévitables tolérances mécaniques, il existera généralement un décalage dans la direction z entre chaque plaque de guidage de liquide et le disque correspondant. Des simulations 2D des écoulements ont été effectuées pour trois cas de figure, illustrés par les figures 3A, 3B et 3C :
Figure 3A : interstice de 500 µm et décalage de 200 µm ;
Figure 3B: interstice de 1 mm et décalage nul ;
Figure 3C : interstice de 550µm et décalage de 50µm.

On peut remarquer que l'écoulement est confiné dans l'espace entre la surface principale supérieure (non représentée) du premier disque et la paroi supérieure du carter (non représentée) ; entre la surface principale inférieure S₁₂ du premier disque et la surface principale supérieure S₂₁ du deuxième disque ; entre la surface principale inférieure S₂₂ du deuxième disque et la surface principale supérieure S₃₁ du troisième disque ; et entre la surface principale inférieure S₃₂ du troisième disque et la paroi inférieure du carter.

Il est important d'avoir à l'esprit la différence entre recirculations de fluide et turbulences. Une recirculation de fluide est stationnaire ou quasi stationnaire ; elle peut être laminaire ou turbulente. Une turbulence varie rapidement dans le temps, sa dimension est le plus souvent bien inférieure à la taille d'une recirculation. Le plus souvent, les recirculations rapides s'accompagnent de turbulences.

Dans le cas de la figure 3A, le rétrécissement du second canal en partant du haut entraine un ralentissement du fluide dû aux forces de friction qui deviennent importantes. Les lignes de flux sont perturbées dans le canal central soumis à un décalage de 200µm. Des effets de recirculation sont générés juste après l'interstice, à une vitesse importante. Des turbulences (non visibles par la simulation) peuvent apparaître à cet endroit. A l'évidence, un décalage de 200 µm est trop important pour un écoulement optimal.

Dans le cas de la figure 3B, on observe des recirculations importantes dans l'interstice, mais qui ne perturbent pas le flux principal, parce qu'elles s'effectuent à faible vitesse.

Dans le cas de la figure 3C, correspondant à un décalage de 50 µm, les perturbations du flux principal demeurent acceptables ; surtout, elles relaxent en l'espace de quelques millimètres, de telle sorte que l'écoulement redevient laminaire avant d'atteindre le bord du faisceau laser. On peut donc prendre une tolérance de l'ordre de 50 µm pour l'alignement des plaques et des disques.

En plus de la maîtrise de la laminarité de l'écoulement du liquide de refroidissement, la gestion du rayonnement parasite d'émission spontanée amplifiée (ASE, de l'anglais « Amplified Spontaneous Emission ») constitue un aspect important de l'émission. En effet, plus de 75% de l'énergie incidente, apportée par le faisceau de pompe qui est presque entièrement absorbée, est réémise sous la forme de rayonnement ASE (contre 15 - 20 % d'énergie transférée au faisceau laser à amplifier, la partie restante étant absorbée par le milieu actif et directement transformée en chaleur). Ce rayonnement est presque entièrement émis dans la direction transversale (plan xy), car le gain y est beaucoup plus important que dans la direction de l'épaisseur des disques (z).

Si aucune précaution particulière n'est prise, le rayonnement ASE risque de chauffer excessivement le carter, et par conséquent le liquide de refroidissement. Dans les têtes amplificatrices des figures 1 et 2A/2B cela est évité de la manière suivante :
- Premièrement, tant les plaques de guidage du liquide de refroidissement PGL1, PGL2, PGL3 que les parois séparatrices PSE1, PSE2 sont transparentes dans la bande spectrale de ce rayonnement, de manière à ne pas l'absorber et s'échauffer à proximité des disques de milieu actif laser. Ainsi, le rayonnement ASE peut se propager librement à travers ces éléments, loin du milieu actif.
- Un miroir MDA, par exemple de forme triangulaire, est agencé à l'extrémité des plaques de guidage du liquide de refroidissement PGL1, PGL2, PGL3 la plus éloignée des disques de milieu actif laser. La fonction de ce miroir est de dévier le rayonnement ASE dirigé vers l'arrivé de liquide de refroidissement vers les côté du carter. En l'absence du miroir MDA, le rayonnement serait absorbé par la région du carter proche du port d'arrivé du liquide de refroidissement, qui serait chauffé avant même de parvenir aux disques.

- Des structures diffusantes et absorbantes SAD1, SAD2 sont agencées sur les côtés du carter. Ces structures sont par exemple constituées de réseaux de plots métalliques (par exemple en cuivre) présentant une surface absorbante (par exemple en chrome noir). Elles diffusent et absorbent le rayonnement ASE avant qu'il atteigne les parois du carter, et empêchent toute rétrodiffusion de ce rayonnement vers le disque. Le rayonnement réfléchi par le miroir MDA parvient également aux structures SAD1, SAD2. Ces structures sont refroidies par le liquide (tiède) qui s'écoule en direction du port de sortie. En outre, elles ont tendance à rendre l'écoulement de ce liquide encore plus turbulent, ce qui augmente le coefficient d'échange thermique. Une structure diffusante et absorbante pourrait également être prévue dans le « bas » du carter (après la rainure RF dans le cas des figures 2A/2B), mais cela est moins important car cette région est plus éloignée de la zone active des disques, et le rayonnement ASE y parvient atténué.

La figure 4 illustre la propagation du rayonnement ASE dans la tête amplificatrice de la figure 2, simulée au moyen d'un algorithme de lancer de rayons.

La figure 5 illustre un amplificateur optique mettant en œuvre une tête amplificatrice du type représenté sur la figure 1 ou sur les figures 2A/B. L'arbre A est actionné en rotation par le moteur électrique M. Un circuit fluidique contenant du liquide de refroidissement est relié au port d'entrée et au port de sortie du carter, une pompe PLR étant prévue à proximité du port d'entrée pour provoquer un écoulement, à un débit voulu, dudit liquide. Le carter présente deux fenêtres FE1, FE2 agencées en vis-à-vis, de part et d'autre des disques DA1- DA3. Un faisceau laser de pompe FLP, émis par une source laser de pompe LAP, typiquement à diodes, traverse un miroir dichroïque MD, puis pénètre dans le carter par la fenêtre FE2 ; il est absorbé presque entièrement par les disques de milieu actif laser. Le faisceau laser à amplifier (ou « signal ») entre dans le carter par la fenêtre FE1, traverse les disques DA1 - DA3 qui l'amplifient, sort de la fenêtre FE2, est réfléchi par le miroir dichroïque MD, pénètre à nouveau dans le carter par la fenêtre FE2, traverse une deuxième fois les disques de milieu actif laser qui l'amplifient encore davantage, puis sort de la fenêtre FE1 et se propage dans une direction opposée à celle d'arrivée.

La séparation entre le faisceau laser amplifié et le faisceau de pompe peut se faire au moyen d'un deuxième miroir dichroïque ou d'un polariseur, ou alors en exploitant un léger décalage angulaire. De même, le faisceau laser amplifié peut être légèrement décalé angulairement du faisceau entrant dans la tête laser de manière à permettre son extraction ; cela rend également possible d'effectuer plusieurs passages dans le milieu amplificateur. En variante, l'extraction du faisceau amplifié peut se faire par rotation de polarisation au moyen d'une lame quart d'onde et d'une cellule de Pockels associée à un polariseur.

La tête laser de la figure 1 a fait l'objet d'une modélisation thermique. Une simulation a été effectuée avec les paramètres suivants :
- Puissance pompe incidente : 16kW/cm² soit 13kW total ;
- Coefficient de conversion énergie laser-chaleur (défaut quantique) : 0,1 ;
- Diamètre du faisceau pompe : 10 mm ;
- Diamètre du faisceau laser à amplifier : 8mm ;
- Coefficient d'échange thermique en convection forcée estimé à h=5000 Wm⁻²K⁻¹ ;
- Température du fluide de refroidissement en entrée : 10°C ;
- Rayon de rotation : 25 mm ;
- Vitesse de rotation : 2 tours/seconde
- Rayon des disques : 70 mm ;
- Epaisseur disque DA1 = 2.35 mm, dopage 1,5%, absorption 160.5 m⁻¹ ;
- Epaisseur disque DA2 = 2.35 mm, dopage 2,0%, absorption 214 m⁻¹ ;
- Epaisseur disque DA3 = 3.22 mm, dopage 2,0%, absorption 214 m⁻¹.

Dans l'amplificateur, un dopage à 2% moyen et une épaisseur traversée totale 9 mm permet d'absorber plus de 95 % de la pompe.

La simulation montre que la température moyenne centrale des disques, une fois que le régime permanent est établi, ne dépasse pas 50°C ; la surface des disques, quant à elle, reste à environ 35°C. La chaleur est concentrée sur un anneau de largeur égale au diamètre du faisceau de pompe, ce qui montre que la conductivité thermique n'est pas suffisante pour espérer une évacuation de la chaleur par les côtés et justifie le choix de séparer le milieu amplificateur en trois disques d'épaisseur moindre afin de permettre d'évacuer la chaleur du centre vers la surface avec un écart de température raisonnable (environ 10°C). Une variation temporelle, dont la valeur maximale est de l'ordre de +/- 7°C, se superpose à cette température moyenne en raison des phases successives de chauffage et de refroidissement provoquées par la rotation des disques. Ainsi, la température instantanée maximale des disques n'excède pas 57°C.

La dilatation thermique déforme les disques, qui prennent la forme d'assiette avec une déformation maximale de 3,5 µm. Les contraintes se concentrent sur la trace du faisceau avec un maximum de 6,22×10⁷ Pa. Cette valeur reste inférieure de trois ordres de grandeurs au module d'Young, ce qui montre que l'on reste dans le domaine des contraintes et déformations élastiques, loin des seuils de rupture mécanique du composant.

L'échauffement des disques et des lames de liquide qui les séparent induisent des perturbations optiques, qui sont dues à la fois à la dépendance des indices de réfraction de la température (effet de lentille thermique) et à la déformation mécanique des disques.

Il faut noter que les coefficients thermo optiques du YAG et de l'eau sont de signes opposés, ce qui a pour effet de compenser en partie les phénomènes de déviation et de lentille thermique

Les calculs de déviation optique montre que le faisceau laser est dévié d'un angle de quelques dizaines de microradians (µrad) au maximum, ce qui peut être compensé au moyen d'une lentille cylindrique d'axe horizontal et de focale égale à quelques mètres. Les aberrations résiduelles sont estimées en dessous de la longueur d'onde.

Le carter est principalement chauffé par le rayonnement ASE ; grâce à la présence des structures SAD1, SAD2 et du miroir MDA, la température maximale est de l'ordre de 50°C, bien en dessous de la température d'ébullition de l'eau à pression atmosphérique.

L'invention a été décrite en référence à deux modes de réalisation particuliers, mais des nombreuses variantes sont envisageables.

La structure de tête amplificatrice laser objet de l'invention peut être utilisé pour tout milieu actif à l'état solide, qu'il soit monocristallin, polycristallin (céramique) ou amorphe (verre), quelle que soit sa longueur d'onde d'émission et son mode de fonctionnement (impulsionnel ou continu).

Dans le milieu actif peuvent être incorporés à la fois des ions dopants pour l'effet laser, et des co-dopants permettant d'homogénéiser la concentration en ions dopants, ou de modifier le profil spectral du gain. Les différents disques peuvent présenter des caractéristiques différentes : nature de la matrice, dopants et co-dopants, en espèce et en concentration.

Les modes de réalisation décrits utilisent un pompage par diode laser, avec un faisceau de pompe collinéaire au faisceau à amplifier, mais d'autres modes de pompage optique - par exemple, pompage latéral.

Dans le mode de réalisation de la figure 5, le faisceau laser à amplifier effectue un aller-retour dans la tête amplificatrice. Il est cependant possible qu'il effectue un seul passage ; inversement, la tête amplificatrice selon l'invention peut être utilisée dans un amplificateur multi-passage ou régénératif, voire dans un oscillateur laser. Il n'est pas toujours nécessaire que le carter présente deux fenêtres optiques, ou hublot, en vis-à-vis ; par exemple, une seule fenêtre peut suffire, si le carter contient également un miroir réfléchissant le faisceau laser.

Le nombre de disques (et, par conséquent, de plaques de guidage de liquide), ainsi que leur épaisseur, a été donné uniquement à titre d'exemple et peut varier. Les disques de milieu actif laser peuvent être inclinés par rapport au faisceau laser à amplifier, par exemple à l'angle de Brewster, comme dans les références [3] et [4] (ce qui nécessite toutefois une adaptation de l'intensité du faisceau de pompe). Il n'est même pas indispensable qu'ils soient strictement coaxiaux, pourvu qu'ils puissent être traversés en même temps par le faisceau laser à amplifier.

Des dimensions des disques de milieu actif, ainsi que des valeurs d'espacement et des tolérances de décalage et d'interstice entre disques et plaques de guidage de liquide ont été données au titre d'exemples uniquement. Plus généralement, mais également de manière non limitative, les disques peuvent présenter une épaisseur comprise entre 300 µm et 1 cm et un espacement mutuel compris entre 200 µm et 4 mm, du moment que le nombre de Reynolds reste inférieur à 2500. D'autres dimensionnements sont possibles, pourvu qu'un écoulement laminaire du liquide de refroidissement dans la région traversée par le faisceau laser soit assuré.

Il est également possible de remplacer le mouvement de rotation des plaques de milieu actif laser (qui ne seront alors pas nécessairement des « disques » de forme circulaire) par un autre mouvement cyclique, par exemple une oscillation linéaire. On entend par « cyclique » un mouvement périodique, ou plus généralement alternatif, qui revient périodiquement dans une même configuration ; dans ce cas, l'arbre A pourra être remplacé par un autre dispositif de liaison mécanique, tel un guide de coulissement. La forme des plaques de guidage de liquide doit être adaptée à la forme et au mouvement des plaques de milieu actif. En outre, dans le cas d'un mouvement de translation, ce sera de préférence l'ensemble de la tête amplificatrice qui se déplacera par rapport au faisceau laser à amplifier, et non seulement les plaques de milieu actif laser par rapport au carter comme dans le cas des disques en rotation.

Tout autre actionneur peut être utilisé en remplacement du moteur électrique M.

Le liquide de refroidissement utilisé dépendra de la nature chimique du milieu actif et de sa longueur d'onde d'émission. Ses propriétés mécaniques (viscosité, densité) et thermiques (capacité thermique massique, conductivité thermique, température d'ébullition...) guideront le dimensionnement de la tête amplificatrice.

Dans les modes de réalisation des figures 1 et 2A/2B, le liquide de refroidissement « descend » du port d'entrée vers les disques de milieu actif laser, puis « remonte » sur les côtés vers les ports de sortie en traversant les structures absorbantes et diffusantes SAD1, SAD2. En variante, l'écoulement peut se faire dans une seule direction, le port de sortie étant agencé à l'opposé du port d'entrée.

Les structures absorbantes et diffusantes SAD1, SAD2 peuvent avoir une forme et une nature différente de celle illustrée sur les figures. Elles peuvent entourer les disques de milieu actif laser sur tous les côtés (c'est-à-dire également dans le « bas » du carter), voire sur quatre côtés, sauf en correspondance des plaques de guidage du liquide de refroidissement. Au contraire, elles peuvent être absentes, bien que cela dégrade les performances thermiques de l'invention ; dans ce cas, elles peuvent être remplacées par des couronnes absorbantes à la périphérie des disques de milieu actif laser.

Le miroir MDA peut être absent, ou sa forme ne pas être triangulaire (il peut s'agir d'un simple miroir incliné, ou présenter une forme convexe autre que triangulaire).

Les plaques de milieu actif laser peuvent être biseautées et/ou chanfreinées pour limiter les réflexions internes du rayonnement ASE. Dans le mode de réalisation décrit en détail plus haut, cependant, cela n'est pas essentiel : en effet, le coefficient de réflexion à l'interface milieu actif - liquide de refroidissement est seulement de 2,2% et le gain transverse inférieur ou égal à 8, ce qui donne un produit gain-perte inférieur à 0,18 - loin de la valeur de 1 qui rendrait possible une oscillation laser dans la direction transverse. En outre, le faisceau de pompe étant excentré par rapport aux disques de milieu actif, les réflexions sur les bords tendent à repartir l'ASE sur des parties du disque où il n'y a pas de pompage, et donc pas de gain.

Comme cela a été mentionné plus haut, la tête amplificatrice peut être utilisée dans une configuration multi-passage, voire régénérative. En outre, le faisceau de pompe peut être recyclé.

### Références

[1a] BROWN, D.C., KELLY, J.H., ABATE, J.H. Active-Mirror Amplifiers: Progress and Prospects. IEEE Journal of Quantum Electronics, Vol. QE-17, No. 7, September 1981.
[1b]GIESEN, A., HÜGEL, H., VOSS, A., WITTIG, K., BRAUCH, U., OPOWER, H., Scalable Concept for Diode-Pumped High-Power Solid-State Lasers, Appl. Phys. B 58, 365-372 (1994).
[1c] LUCIANETTI, A., ALBACH, D., CHANTELOUP, J.-C., Active-mirror-laser-amplifier thermal management with tunable helium pressure at cryogenic temperatures, Optics Express, Vol. 19, No. 13, 20 June 2011.
[2] NIE, R. Z., SHE, J. B., ZHAO, P. F., et al. Fully immersed liquid cooling thin-disk oscillator. Laser Physics Letters, 2014, vol. 11, no 11, p. 115808.
[3] FU, Xing, LI, Peilin, LIU, Qiang, et al. 3kW liquid-cooled elastically-supported Nd: YAG multi-slab CW laser resonator. Optics express, 2014, vol. 22, no 15, p. 18421-18432.
[4] WANG, Ke, TU, Bo, JIA, Chunyan, et al. 7kW direct-liquid-cooled side-pumped Nd: YAG multi-disk laser resonator. Optics Express, 2016, vol. 24, no 13, p. 15012-15020.
[5] BASU, Santanu. Nd-YAG and Yb-YAG rotary disk lasers. IEEE Journal of selected topics in quantum electronics, 2005, vol. 11, no 3, p. 626-630.
[6] US 2006/0007800
[7] ONGSTAD, Andrew P., GUY, Matthew, et CHAVEZ, Joeseph R. High power Nd: YAG spinning disk laser. Optics Express, 2016, vol. 24, no 1, p. 108-113.
[8] FU, Xing, LIU, Qiang, LI, Peilin, et al. Direct-liquid-cooled Nd: YAG thin disk laser oscillator. Applied Physics B, 2013, vol. 111, no 3, p. 517-521.

## Revendications

1. Tête amplificatrice laser (TL) comprenant une pluralité de plaques (DA1, DA2, DA3) d'un milieu actif laser à état solide disposées dans un carter (C), agencées parallèles les unes aux autres avec leurs surfaces principales (S₁₂, S₂₁, S₂₂, S₃₁) en vis-à-vis , le carter étant pourvu d'un port d'entrée (PEL) et d'un port de sortie (PSL) pour un liquide de refroidissement, ainsi que d'au moins une fenêtre (FE1, FE2) permettant à un faisceau laser (FLS) de traverser les plaques de milieu actif laser, des plaques (PGL1, PGL2, PGL3) de guidage du liquide de refroidissement étant agencées dans le prolongement des plaques de milieu actif laser, entre ces dernières et le port d'entrée dudit liquide, **caractérisé en ce qu'**elle comprend également un dispositif de liaison mécanique (A) permettant un mouvement cyclique au moins des plaques de milieu actif laser par rapport au faisceau laser dans un plan (xy) perpendiculaire à la direction (z) de leur épaisseur ;

2. Tête amplificatrice laser selon la revendication 1 dans laquelle le dispositif de liaison mécanique (A) est configuré pour mettre les plaques de milieu actif laser en rotation autour d'un axe commun, perpendiculaire à la direction de leur épaisseur, par rapport au carter.

3. Tête amplificatrice laser selon la revendication 2 dans laquelle ledit axe commun (z) est parallèle à la direction de propagation du faisceau laser.

4. Tête amplificatrice laser selon l'une des revendications 2 et 3 dans laquelle la ou les fenêtres sont agencée de telle sorte que le faisceau laser traverse une région (RA) desdites plaques de milieu actif laser comprise entre le port d'entrée du liquide de refroidissement et l'axe commun de rotation.

5. Tête amplificatrice laser selon l'une des revendications précédentes dans laquelle les plaques de guidage du liquide de refroidissement sont transparentes dans une bande spectrale d'un rayonnement d'émission spontanée amplifiée (ASE) des plaques de milieu actif laser, de manière à permettre l'évacuation dudit rayonnement.

6. Tête amplificatrice laser selon la revendication 5 comprenant également des miroirs (MDA) pour dévier une portion dudit rayonnement d'émission spontanée amplifiée évacuée à travers les plaques de guidage du liquide de refroidissement et initialement dirigée vers le port d'entrée du liquide de refroidissement.

7. Tête amplificatrice laser selon l'une des revendications 5 ou 6 comprenant également, à l'intérieur dudit carter, au moins une structure optiquement absorbante et diffusante (SAD1, SAD2) dans ladite bande spectrale du rayonnement d'émission spontanée amplifiée, ladite structure optiquement absorbante et diffusante entourant au moins en partie les plaques de milieu actif laser dans un plan perpendiculaire à la direction de leur épaisseur et étant agencée de manière à être en contact avec ledit liquide de refroidissement.

8. Tête amplificatrice laser selon la revendication 7 dans laquelle ladite structure optiquement absorbante et diffusante (SAD1, SAD2) comprend un réseau de plots.

9. Tête amplificatrice laser selon l'une des revendications 7 et 8, comprenant également au moins une paroi transparente (PSE1, PES2) dans ladite bande spectrale du rayonnement d'émission spontanée amplifiée et séparant d'une part une région du volume interne au carter contenant les plaques de milieu actif laser, les plaques de guidage du liquide de refroidissement et le port d'entrée, et d'autre part ladite ou chaque dite structure optiquement absorbante et diffusante et le port de sortie.

10. Tête amplificatrice laser selon l'une des revendications précédentes dans laquelle les plaques de guidage du liquide de refroidissement présentent une largeur inférieure à celle des plaques du milieu actif laser.

11. Tête amplificatrice laser selon l'une des revendications précédentes dans laquelle les plaques de milieu actif laser présentent une épaisseur comprise entre 300 µm et 1 cm et un espacement mutuel compris entre 200 µm et 4 mm.

12. Tête amplificatrice laser selon l'une des revendications précédentes dans laquelle les plaques de milieu actif laser sont en forme de disque.

13. Tête amplificatrice laser selon l'une des revendications précédentes comprenant également une pompe (PLR) reliée fluidiquement au port d'entrée et au port de sortie et adaptée pour provoquer dans le carter un écoulement du liquide de refroidissement, le dimensionnement et l'agencement de la pompe, du carter, des plaques de milieu actif laser et des plaques de guidage du liquide de refroidissement étant adaptés pour que l'écoulement soit laminaire (EL) dans une région traversée par le faisceau laser, puis effectue une transition (ETr) vers un régime turbulent (ETu).

14. Tête amplificatrice laser selon l'une des revendications précédentes, comprenant également un actionneur (M) coopérant avec le dispositif de liaison mécanique pour provoquer ledit mouvement cyclique des plaques de milieu actif.

15. Tête amplificatrice laser selon l'une des revendications précédentes, comprenant également un système de pompage optique longitudinal (LAP).

## Patentansprüche

1. Laserverstärkerkopf (TL), der eine Vielzahl von Platten (DA1, DA2, DA3) aus einem laseraktiven Feststoffmedium umfasst, die in einem Gehäuse (C) untergebracht sind, die zueinander mit ihren Hauptflächen (S₁₂, S₂₁, S₂₂, S₃₁) einander gegenüberliegend angeordnet sind, wobei das Gehäuse mit einer Einlassöffnung (PEL) und einer Auslassöffnung (PSL) für eine Kühlflüssigkeit sowie mit mindestens einem Fenster (FE1, FE2) versehen ist, durch das ein Laserstrahl (FLS) die Platten aus laseraktivem Medium durchqueren kann, wobei Kühlflüssigkeitsführungsplatten (PGL1, PGL2, PGL3) in der Verlängerung der Platten aus laseraktivem Medium zwischen diesen und dem Einlass der Flüssigkeit angeordnet sind, **dadurch gekennzeichnet, dass** er auch eine mechanische Verbindungsvorrichtung (A) umfasst, die eine zyklische Bewegung mindestens der Platten aus laseraktivem Medium in Bezug auf den Laserstrahl in einer Ebene (xy) lotrecht zu der Richtung (z) ihrer Dicke ermöglicht.

2. Laserverstärkerkopf nach Anspruch 1, wobei die mechanische Verbindungsvorrichtung (A) konfiguriert ist, um die Platten aus laseraktivem Medium um eine gemeinsame Achse lotrecht zur ihrer Dickenrichtung relativ zum Gehäuse zu drehen.

3. Laserverstärkungskopf nach Anspruch 2, wobei die gemeinsame Achse (z) parallel zur Ausbreitungsrichtung des Laserstrahls ist.

4. Laserverstärkerkopf nach einem der Ansprüche 2 und 3, wobei das oder die Fenster so angeordnet sind, dass der Laserstrahl eine Region (RA) der Platten aus laseraktivem Medium zwischen dem Kühlflüssigkeitseinlass und der gemeinsamen Drehachse durchquert.

5. Laserverstärkerkopf nach einem der vorherigen Ansprüche, wobei die Kühlflüssigkeitsführungsplatten in einem Spektralband einer verstärkten spontanen Emissionsstrahlung (ASE) der Platten aus laseraktivem Medium transparent sind, so dass die Strahlung entfernt werden kann.

6. Laserverstärkerkopf nach Anspruch 5, der auch Spiegel (MDA) zum Ablenken eines Teils der verstärkten spontanen Emissionsstrahlung umfasst, die durch die Kühlflüssigkeitsführungsplatten entfernt wird und anfänglich auf den Kühlflüssigkeitseinlass gerichtet ist.

7. Laserverstärkerkopf nach einem der Ansprüche 5 oder 6, der innerhalb des Gehäuses auch mindestens eine optisch absorbierende und streuende Struktur (SAD1, SAD2) in dem Spektralband der verstärkten spontanen Emissionsstrahlung umfasst, wobei die optisch absorbierende und streuende Struktur die Platten aus laseraktivem Medium in einer Ebene lotrecht zu ihrer Dickenrichtung mindestens teilweise umgibt und so angeordnet ist, dass sie mit der Kühlflüssigkeit in Kontakt steht.

8. Laserverstärkerkopf nach Anspruch 7, wobei die optisch absorbierende und streuende Struktur (SAD1, SAD2) eine Anordnung von Zapfen umfasst.

9. Laserverstärkerkopf nach einem der Ansprüche 7 und 8, der auch mindestens eine Wand (PSE1, PES2) umfasst, die in dem Spektralband der verstärkten spontanen Emissionsstrahlung transparent ist und einerseits eine Region des Innenvolumens des Gehäuses, das die Platten aus laseraktivem Medium, die Kühlflüssigkeitsführungsplatten und den Einlassanschluss enthält, und andererseits die oder jede optisch absorbierende und streuende Struktur und den Auslassanschluss trennt.

10. Laserverstärkerkopf nach einem der vorherigen Ansprüche, wobei die Kühlmittelführungsplatten eine geringere Breite haben als die Platten aus laseraktiven Medium.

11. Laserverstärkerkopf nach einem der vorherigen Ansprüche, wobei die Platten aus laseraktivem Medium eine Dicke zwischen 300 µm und 1 cm und einen Abstand zwischen 200 µm und 4 mm zueinander aufweisen.

12. Laserverstärkerkopf nach einem der vorherigen Ansprüche, wobei die Platten aus laseraktivem Medium scheibenförmig sind.

13. Laserverstärkerkopf nach einem der vorherigen Ansprüche, der auch eine Pumpe (PLR) umfasst, die fluidisch mit der Einlassöffnung und der Auslassöffnung verbunden und zum Bewirken einer Strömung der Kühlflüssigkeit im Gehäuse ausgelegt ist, wobei die Größe und die Anordnung der Pumpe, des Gehäuses, der Platten aus laseraktivem Medium und der Kühlflüssigkeitsleitplatten so ausgelegt sind, dass die Strömung in einer Region, die der Laserstrahl durchquert, laminar (EL) ist und dann einen Übergang (ETr) in einen turbulenten Zustand (ETu) bewirkt.

14. Laserverstärkerkopf nach einem der vorherigen Ansprüche, der auch einen Aktuator (M) umfasst, der mit der mechanischen Verbindungsvorrichtung zusammenarbeitet, um die zyklische Bewegung der Platten aus aktivem Medium zu bewirken.

15. Laserverstärkerkopf nach einem der vorherigen Ansprüche, der auch ein optisches Längspumpsystem (LAP) umfasst.

## Claims

1. A laser amplifier head (TL) comprising a plurality of plates (DA1, DA2, DA3) of a solid-state laser active medium disposed in a housing (C), arranged parallel to one another with their main surfaces (S₁₂, S₂₁, S₂₂, S₃₁) facing one another, the housing being provided with an inlet port (PEL) and an outlet port (PSL) for a cooling liquid, and also at least one window (FE1, FE2) allowing a laser beam (FLS) to pass through the laser active medium plates, cooling liquid guide plates (PGL1, PGL2, PGL3) arranged in the extension of the laser active medium plates, between the latter and the inlet port of said liquid, **characterised in that** it also comprises a mechanical connection device (A) allowing a cyclic movement at least of the laser active medium plates in relation to the laser beam in a plane (xy) perpendicular to the direction (z) of their thickness.

2. The laser amplifier head according to claim 1, wherein the mechanical connection device (A) is configured to cause the laser active medium plates to rotate around a common axis, perpendicular to the direction of their thickness, in relation to the housing.

3. The laser amplifier head according to claim 2, wherein said common axis (z) is parallel to the direction of propagation of the laser beam.

4. The laser amplifier head according to one of claims 2 and 3, wherein the one or more windows are arranged in such a way that the laser beam passes through a region (RA) of said laser active medium plates between the inlet port of the cooling liquid and the common axis of rotation.

5. The laser amplifier head according to one of the preceding claims, wherein the cooling liquid guide plates are transparent in a spectral band of an amplified spontaneous emission (ASE) radiation of the laser active medium plates, in such a way as to allow the removal of said radiation.

6. The laser amplifier head according to claim 5, also comprising mirrors (MDA) to deflect a portion of said amplified spontaneous emission radiation removed through the cooling liquid guide plates and initially directed toward the inlet port of the cooling liquid.

7. The laser amplifier head according to one of claims 5 or 6, also comprising, inside said housing, at least one optically absorbing and diffusing structure (SAD1, SAD2) in said spectral band of the amplified spontaneous emission radiation, said optically absorbing and diffusing structure at least partially surrounding the laser active medium plates in a plane perpendicular to the direction of their thickness and being arranged in such a way as to be in contact with said cooling liquid.

8. The laser amplifier head according to claim 7, wherein said optically absorbing and diffusing structure (SAD1, SAD2) comprises an array of studs.

9. The laser amplifier head according to one of claims 7 and 8, also comprising at least one transparent wall (PSE1, PES2) in said spectral band of the amplified spontaneous emission radiation and separating, on one hand, a region of the volume within the housing containing the laser active medium plates, the cooling liquid guide plates and the inlet port, and, on the other hand, said or each said optically absorbing and diffusing structure and the outlet port.

10. The laser amplifier head according to one of the preceding claims, wherein the cooling liquid guide plates have a width which is less than that of the laser active medium plates.

11. The laser amplifier head according to one of the preceding claims, wherein the laser active medium plates have a thickness of between 300 µm and 1 cm and a mutual spacing of between 200 µm and 4 mm.

12. The laser amplifier head according to one of the preceding claims, wherein the laser active medium plates are disk-shaped.

13. The laser amplifier head according to one of the preceding claims, also comprising a pump (PLR) which has a fluid connection to the inlet port and to the outlet port and which is suitable for causing a flow of the cooling liquid in the housing, the dimensioning and the arrangement of the pump, the housing, the laser active medium plates and the cooling liquid guide plates being adapted so that the flow is laminar (EL) in a region through which the laser beam passes, then causes a transition (ETr) to a turbulent regime (ETu).

14. The laser amplifier head according to one of the preceding claims, also comprising an actuator (M) interworking with the mechanical connection device to cause said cyclic movement of the active medium plates.

15. The laser amplifier head according to one of the preceding claims, also comprising a longitudinal optical pumping system (LAP).
